Europäisches Patentamt

European Patent Office

Office européen des brevets

(11) Numéro de publication: **0 309 313**
**A1**

## (12) DEMANDE DE BREVET EUROPEEN

(21) Numéro de dépôt: 88402282.3

(22) Date de dépôt: 09.09.88

(51) Int. Cl.⁴: **H 01 L 39/12**
C 04 B 35/00, H 01 L 39/24

(30) Priorité: 18.09.87 FR 8712949

(43) Date de publication de la demande:
29.03.89 Bulletin 89/13

(84) Etats contractants désignés: DE GB NL

(71) Demandeur: THOMSON-CSF
173, Boulevard Haussmann
F-75379 Paris Cédex 08 (FR)

(72) Inventeur: Kormann, René
THOMSON-CSF SCPI 19, avenue de Messine
F-75008 Paris (FR)

Loiseau, Raymond
THOMSON-CSF SCPI 19, avenue de Messine
F-75008 Paris (FR)

(74) Mandataire: Grynwald, Albert et al
THOMSON-CSF SCPI 19, avenue de Messine
F-75008 Paris (FR)

(54) Matériau supraconducteur.

(57) L'invention concerne un matériau à base d'oxyde de baryum, de cuivre d'yttrium et d'un métal tel que du nickel ou du cobalt.

Ce matériau a une transition résistive nettement abrupte et est applicable dans tout composant électrotechnique ou electronique.

FIG. 2

$Y Ba_2 Cu_{2,9} Co_{0,1} O_{8-\delta}$

EP 0 309 313 A1

## Description

### MATERIAU SUPRACONDUCTEUR

L'invention concerne un matériau supraconducteur présentant une transition supraconductrice abrupte.

Une des propriété des matériaux supraconducteurs est l'annulation de leur résistance électrique lorsqu'on fait décroître la température. Actuellement, les études en cours visent à obtenir des matériaux qui deviennent supraconducteurs à des températures de plus en plus élevées et qui tendent vers la température ambiante.

La transition résistive ou largeur de la transition caractérise la différence entre l'état de la température "ONSET" à laquelle le matériau commence à s'écarter de l'état à haute température et l'état à la température à laquelle le matériau possède une résistance quasiment nulle. Il est à souligner qu'il est intéressant que cette transition résistive soit la plus abrupte possible c'est-à-dire que la largeur de transition soit la plus faible possible.

L'invention fournit un matériau répondant à cette exigence.

L'invention concerne un matériau supraconducteur caractérisé en ce qu'il est constitué essentiellement par un oxyde de baryum, de cuivre, d'yttrium et d'un métal pouvant être du nickel ou du cobalt.

L'invention concerne également un procédé de réalisation d'un matériau supraconducteur selon la revendication 1, caractérisé en ce qu'il comporte les étapes suivantes :
- mélange de poudres d'oxyde d'yttrium ($Y_2 O_3$) de carbonate de baryum ($Ba CO_3$), d'oxyde de cuivre (CuO) et d'un oxyde de nickel ou de cobalt ($N_iO$ ou $Co_2 O_4$)
- chamottage du mélange obtenu ;
- compactage sous pression de la poudre ;
- frittage sous oxygène.

Les différents objets et caractéristiques de l'invention apparaîtront plus clairement dans la description qui va suivre faite à titre d'exemple en se reportant aux figures annexées qui représentent des courbes mettant en évidence la transition résistive des matériaux selon l'invention.

La figure 1 représente une courbe de variation mettant en évidence la transition résistive d'un matériau de composition connue.

Les figures 2 et 3 représentent des courbes de variation mettant en évidence les transitions résistives de matériaux de compositions selon l'invention.

Les matériaux selon l'invention sont constitués d'oxydes métalliques, plus précisément ils possèdent une composition en moles du type :

$$Y \, Ba_2 \, Cu_{3-x} \, M_x \, O_{8-\delta}$$

Dans cette composition :
- les paramètres x et $\delta$ ont des valeurs comprises entre 0 et 1 ;
- M désigne un métal choisi parmi les éléments nickel ou cobalt.

Des mesures effectuées sur de tels matériaux ont permis de mettre en évidence la transition abrupte de passage à l'état supraconducteur du matériau sur la caractéristique de résistance en fonction de la température.

Sur les figures annexées on trouve des courbes représentatives des variations de résistivités exprimées en milliohm.cm en fonction de la température exprimée en degrés Kelvin pour différents matériaux. Aux très faibles valeurs de résistances, c'est-à-dire à très faible température, les valeurs des résistances difficiles à mesurer ont été représentées en pointillées.

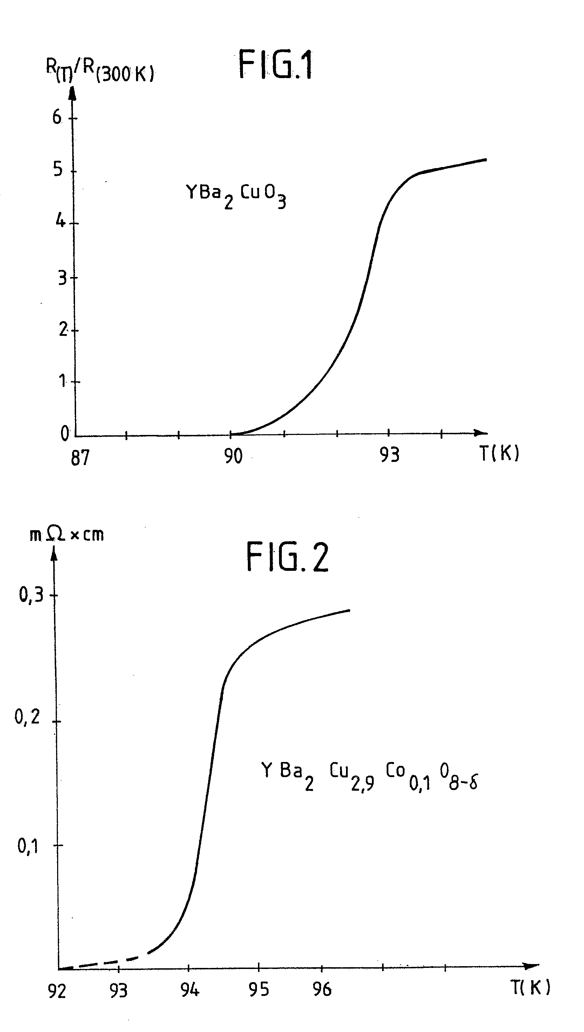

La figure 1 représente une courbe de variation de résistance d'un matériau de composition comme $Y \, Ba_2 \, Cu \, O_3$.

La figure 2 représente une courbe de variation de la résistivité en fonction de la température pour un matériau de composition $Y \, Ba_2 \, Cu_{2,9} \, Co_{0,1} \, O_{8-\delta}$ avec $\delta$ compris entre 0 et 2.

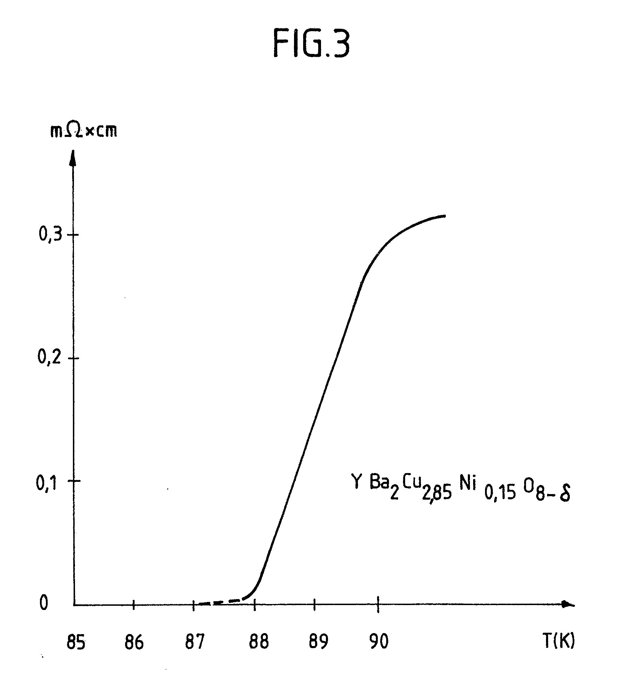

La figure 3 représente une courbe de variation de résistivité pour un matériau de composition $Y \, Ba_2 \, Cu_{2,85} \, Ni_{0,15} O_{8-\delta}$.

De plus, les matériaux de l'invention présentent, pour certaines valeurs de x, l'avantage par rapport à $Y \, Ba_2 \, Co_3 \, O_{8-\delta}$ d'avoir une température de transition supraconductrice plus élevée c'est ainsi que l'on peut indiquer à titre d'exemple que des mesures ont donné les résultats de températures critiques suivantes :
- pour $Y \, Ba_2 \, Cu_{2,90} \, Co_{0,10} \, O_{8-\delta}$ , température critique $T_c = 95K$, $\Delta T_c < 1K$
- pour $Y \, Ba_2 \, Cu_3 \, O_{8-\delta}$, température critique $T_c = 93,5K$, $\Delta t_c \cong 2,5K$.

La comparaison des figures 2 et 3 à la figure 1 met en évidence l'avantage des matériaux selon l'invention par rapport aux matériaux connus.

La transition résistive, nettement abrupte, telle que représentée sur les figures annexées, présente un intérêt pour l'utilisation. Dans les matériaux connus la température de transition $T_c$ appelée température critique est difficile à situer entre la température "ONSET", située à la partie supérieure à la transition sur la caractéristique résistance/température, et la température "OFFSET" à laquelle le matériau est réellement à l'état supraconducteur. Par contre le matériau selon l'invention présente une transition brutale. Les températures d'ONSET et d'OFFSET diffèrent peu et la température critique est située à une température que très légèrement plus faible que la température "ONSET".

La caractéristique de la figure annexée a été réalisée avec un échantillon placé dans un cryostat. Les valeurs ont été mesurées en quatre points en utilisant un nanovoltomètre et un générateur de courant de mesure.

Les matériaux de l'invention trouveront une application préférentielle dans la fabrication des dispositifs électrotechniques (aimant supraconducteur, conducteur électrique) et en électronique tels que dans les composants utilisant l'effet Josephson, guides d'ondes, les cavités résonnantes.

L'invention prévoit de réaliser le matériau supraconducteur ainsi décrit à partir de :

- oxyde d'yttrium (Y$_2$ O$_3$)
- carbonate de baryum (Ba CO$_3$)
- oxyde de nickel (NiO) ou oxyde de cobalt (Co$_3$O$_4$)
- oxyde de cuivre (CuO).

Les différentes étapes du procédé de réalisation selon l'invention sont les suivantes :
- pesée des matières premières qui sont l'oxyde d'yttrium (Y$_2$ O$_3$), le carbonate de baryum (Ba CO$_3$), l'oxyde de nickel (NiO) ou l'oxyde cobalt (Co$_2$ O$_4$) et l'oxyde de cuivre (CuO)
- mélange dans une pulvérisette dans les proportions suivantes :
- 1,5126 grammes de Y$_2$
- 5,2892 grammes de Ba Co$_3$
- 3,0369 grammes de Cu O
- 0,1613 grammes de Co$_3$ O$_4$
- 20 cc d'alcool éthylique ou de liquide volatile,
- durée 30 minutes
- séchage
- chamottage de la poudre sous oxygène selon un procédé connu dans la technique avec
- compactage de la poudre 2T/cm$^2$ dans un moule en acier de diamètre 18 mm
- montée à 100°C/h
- palier à 900°C pendant 16h
- descente à 100°C/h
- palier à 500°C pendant 4h
- descente à 100°C/h
- tamisage 400 microns
- frittage sous oxygène
- montée à 100°C/h
- palier à 1000°C pendant 16h
- descente à 100°C/h
- palier à 500°C pendant 4h
- descente à 100°C/h.

Il est bien évident que la description qui précède n'a été faite qu'à titre d'exemple non limitatif. D'autres variantes peuvent être envisagées sans sortir du cadre de l'invention. Notamment les exemples numériques et les produits employés dans la réalisation du matériau selon l'invention n'ont été fournis que pour illustrer la description.

**Revendications**

1. Matériau supraconducteur caractérisé en ce qu'il est constitué essentiellement par un oxyde de baryum, de cuivre, d'yttrium et d'un métal pouvant être du nickel ou du cobalt.

2. Matériau supraconducteur selon la revendication 1, caractérisé en ce que sa composition est du type
Y Ba$_2$ Cu$_{3-x}$ M$_x$ O$_{8-\delta}$ ,
les valeurs de x et δ étant comprises entre 0 et 1 et M désignant du nickel ou du cobalt.

3. Matériau supraconducteur selon la revendication 2, caractérisé en ce que sa composition est du type :
Y Ba Cu$_{2,9}$ Co$_{0,1}$ O$_{8-\delta}$

4. Procédé de réalisation d'un matériau supraconducteur selon la revendication 1, caractérisé en ce qu'il comporte les étapes suivantes :
- mélange de poudres d'oxyde d'yttrium (Y$_2$ O$_3$) de carbonate de baryum (Ba CO$_3$), d'oxyde de nickel (NiO) ou de cobalt (Co$_2$ O$_4$) et d'oxyde de cuivre (CuO);
- chamottage du mélange obtenu
- compactage sous pression de la poudre
- frittage sous oxygène.

5. Procédé selon la revendication 4, caractérisé en ce que le mélange des différentes poudres d'oxydes est réalisé dans un liquide volatile et qu'un séchage de la poudre est réalisé après le mélange et avant le chamottage.

6. Procédé selon la revendication 4, caractérisé en ce que l'étape de compactage est précédée d'une étape de tamisage.

7. Procédé selon la revendication 4, caractérisé en ce que l'étape de chamottage se fait selon un cycle de température compris entre 100°C et 12000°C.

8. Procédé selon la revendication 4, caractérisé en ce que l'étape de frittage se fait selon un cycle de températures pouvant atteindre 1200°C.

## FIG.1

$R_{(T)}/R_{(300\,K)}$

6 —

5 —

4 —

3 —

2 —

1 —

0 —

$YBa_2\,CuO_3$

87    90    93    T(K)

## FIG.2

$m\Omega \times cm$

0,3 —

0,2 —

0,1 —

$Y\,Ba_2\ Cu_{2,9}\ Co_{0,1}\ O_{8-\delta}$

92    93    94    95    96    T(K)

# FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PHYSICAL REVIEW B, vol. 35, no. 16, 1 juin 1987, pages 8782-8784, New York, US; G. XIAO et al.: "Effect of transition-metal elements on the superconductivity of Y-Ba-Cu-O" * Page 8782, colonne 1, lignes 22-39; figure 1; tableau I * | 1,2,4,8 | H 01 L 39/12<br>C 04 B 35/00<br>H 01 L 39/24 |
| Y | IDEM. | 5-7 | |
| A | IDEM.<br>--- | 3 | |
| Y | ADVANCED CERAMIC MATERIALS, vol. 2, no. 3B, 20 juillet 1987, pages 364-371, Westerville, Ohio, US; D.W. JOHNSON et al.: "Fabrication of ceramic articles from high Tc superconducting oxides" * Page 364, 10 dernières lignes; page 365, lignes 1-9 * | 5-7 | |
| A | IDEM.<br>--- | 4,8 | DOMAINES TECHNIQUES RECHERCHES (Int. Cl.4) |
| X | NATURE, vol. 328, 6 août 1987, pages 512-514, Basingtoke, GB; Y. MAENO et al.: "Substitution for copper in a high-Tc superconductor YBa2Cu3O7-delta * En entier * | 1-3 | H 01 L |
| A | IDEM.<br>---                    -/- | 4,7,8 | |

Le présent rapport a été établi pour toutes les revendications

| Lieu de la recherche | Date d'achèvement de la recherche | Examinateur |
|---|---|---|
| LA HAYE | 13-12-1988 | MORVAN D.L.D. |

Office européen
des brevets

**RAPPORT DE RECHERCHE EUROPEENNE**

Numero de la demande

EP   88 40 2282

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PHYSICA, PROCEEDINGS OF THE YAMADA CONFERENCE XVIII ON SUPERCONDUCTIVITY IN HIGHLY CORRELATED FERMION SYSTEMS, Sendai, JP, vol. 148 B+C, Nos. 1-3, 31 août - 3 septembre 1987, pages 357-359, Amsterdam, NL; Y. MAENO et al.: "Superconductivity in modified systems based on YBa2Cu3O7-delta * Page 357, colonne 2, ligne 6 - page 358, colonne 1, ligne 5; figure 2 * | 1-3 | |
| A | IDEM. --- | 4,7,8 | |
| A | ADVANCED CERAMIC MATERIALS, vol. 2, no. 3B, 20 juillet 1987, pages 668-677, Westerville, Ohio, US; C.M. SUNG et al.: "Microstructure, crystal symmetry and possible new compounds in the system Y1Ba2Cu3O9-x" * Page 669, paragraphe 2 * ----- | 4,5,7,8 | |

DOMAINES TECHNIQUES RECHERCHES (Int. Cl.4)

Le présent rapport a été établi pour toutes les revendications

| Lieu de la recherche | Date d'achèvement de la recherche | Examinateur |
|---|---|---|
| LA HAYE | 13-12-1988 | MORVAN D.L.D. |

EPO FORM 1503 03.82 (P0402)